# EUROPEAN PATENT APPLICATION

(11) **EP 3 588 181 A1**
(43) Date of publication of application: **01.01.2020**
(21) Application number: 19182082.8
(22) Date of filing: 24.06.2019
(51) Int. Cl.: G02F 1/1347, H01L 51/50, G02F 1/163, G02F 1/157, G02F 1/1506, G02F 1/139, G02F 1/1335

(54) **OPTICAL APPARATUS AND DRIVING METHOD THEREOF**

(30) Priority: 25.06.2018 JP 2018120270
(71) Applicant: STANLEY ELECTRIC CO., LTD., Tokyo 153-8636 (JP)
(72) Inventor: KATO, Keisuke, Tokyo, 153-8636 (JP)
(74) Representative: Carstens, Dirk Wilhelm

(57) **Abstract**

An optical apparatus includes first and second mirror devices disposed to oppose each other, each being capable of taking partially reflective state; and an image displaying device disposed between or on one outer side of the first and second mirror devices, and being capable of displaying an image.

## Description

### BACKGROUND OF THE INVENTION

### FIELD OF THE INVENTION

This invention relates to an optical apparatus and a driving method thereof, and more particularly to an optical apparatus capable of forming a display image having a depth of view and a driving method thereof.

### DESCRIPTION OF THE RELATED ART

Various displays which display letters, figures, images, etc. are known. Liquid crystal display (LCD) which is a flat panel display having a planar display surface is widely used. There are many kinds of instruments, for example LCDs which selectively display plural kinds of segment electrodes of particular shapes, LCDs equipped with multiplicity of pixels distributed in rows and columns (dot matrix) in a plane and being capable of displaying letters, etc. The LCD has a structure in which a liquid crystal layer is sandwiched between a pair of opposing substrates equipped with electrodes. Orientations of liquid crystal molecules can be controlled by controlling voltages applied between the electrodes on the opposing substrates. Polarizers disposed on both sides of the liquid crystal layer visualize the orientations of the liquid crystal molecules, and use them for displays.

LCDs do not emit lights. Display can be done by introducing external lights into LCD. When a liquid crystal display device equipped with light source (back light) is formed, a display device which can achieve display even in circumstances with poor external lights can be provided. A reflection type liquid crystal display device can also be formed through controlling reflection of external lights by controlling orientation of liquid crystal molecules in the device.

When a pair of transparent substrates provided with transparent electrodes are disposed to oppose each other to accommodate an electrolytic liquid including Ag between the opposing electrodes, and a voltage is applied between the opposing electrodes, an Ag film capable of functioning as a reflection mirror is precipitated or deposited on a negatively biased electrode. A cell containing the electrolytic liquid can function firstly as a transparent element when an Ag film has not been precipitated, secondly as a half (partially reflective) mirror which partially reflects incident light and transmits the rest of incident light when a thin Ag film has been precipitated, and thirdly as a mirror when an Ag film of sufficient thickness has been precipitated. When the applied voltage is released, the Ag film will be dissolved. In this way, a mirror surface of desired optical reflectivity according to necessity can be formed on the transparent member.

There is known a display device in which in front of an image display such as a liquid crystal display, a mirror function unit which can selectively take either a light transmission state allowing transmission of external lights or a mirror state reflecting external lights by varying polarization axis of the incident lights is disposed (for example, see JPA 2001-318374).

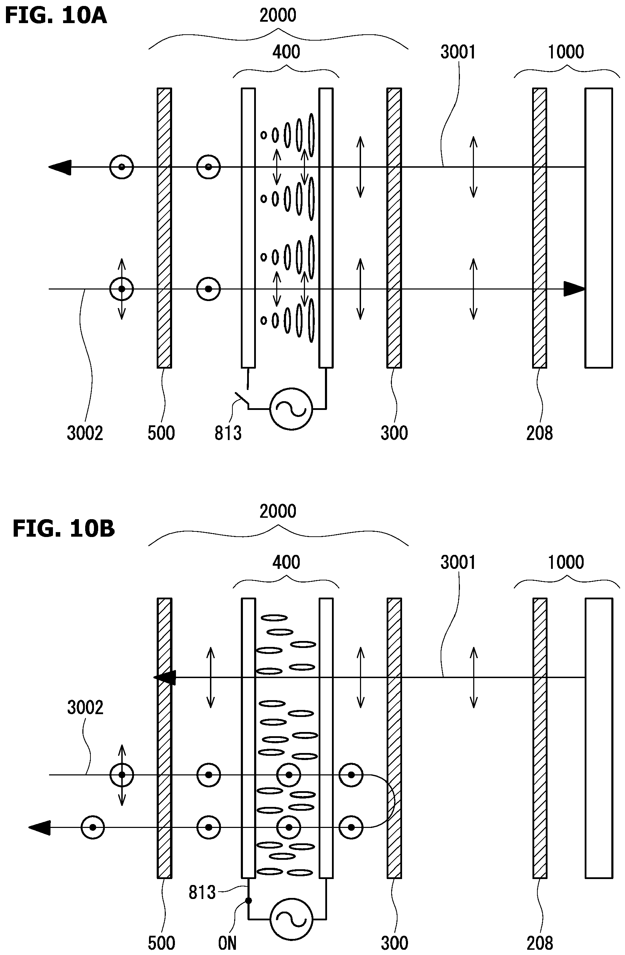

As shown in Fig. 10A, in front of an image display 1000 for emitting image lights for displaying an image, a mirror functioning unit 2000 is disposed overlapping the image display. The mirror functioning unit 2000 can switch between an image transmitting state which transmits the image lights and a mirror state which reflects the external lights. In the mirror functioning unit 2000, there are provided from the side of the image display 1000, a transmission/reflection type polarizer 300, means for varying transmitting polarization axis (twisted nematic (TN) type liquid crystal element) 400, and a transmission/absorption type polarizer 500.

The transmission/reflection type polarizer 300 transmits first polarization of predetermined polarization axis, and reflects second polarization having polarization axis crossing the first polarization. The TN type liquid crystal element 400 can switch between a state of changing the incident first polarization to the second polarization and transmitting the second polarization, and a state of transmitting the incident light without changing the polarization axis. Regarding the first and the second polarizations, the transmission/absorption type polarizer 500 transmits one polarization and absorbs the other polarization.

The image display 1000 is provided with a transmission/absorption type polarizer 208 which transmits the first polarization and absorbs the second polarization, and emits the first polarization transmitted through the transmission/absorption type polarizer 208 to the mirror functioning unit 2000 as the image lights. The transmission/reflection type polarizer 300 transmits the incident first polarization. In the figure, vertical arrow and circle around a dot represent polarization directions.

The TN type liquid crystal element 400 in the absence of an applied voltage, provides 90 degrees twist to the liquid crystal molecules. Light 3001 emitted from the image display 1000, which is a vertical polarization, transmits through the transmission/reflection type polarizer 300, changes the polarization axis by 90 degrees in the TN type liquid crystal element 400, transmits through the transmission/absorption type polarizer 500, and goes outside. Regarding the light 3002 injecting from the outside, only the polarization in the horizontal direction is allowed to transmit through the transmission/absorption type polarizer 500, changes the polarization axis by 90 degrees in the TN type liquid crystal element 400 to become polarization in the vertical direction, and transmits through the transmission/reflection type polarizer 300 and the transmission/absorption type polarizer 208.

Fig. 10B is a cross section illustrating a state where a voltage is applied to the TN type liquid crystal element 400 to raise the liquid crystal molecules vertical to the substrate so as to let the polarization axis of the incident light not change and allow the incident light to transmit through the element. The exit light from the image display 1000 transmits through the TN type liquid crystal element 400 without changing the vertical polarization axis, and is shaded by the transmission/absorption type polarizer 500. Among the lights 3002 externally incident on the mirror functioning unit 2000, only the polarization of the horizontal direction transmits through the transmission/absorption type polarizer 500, transmits through the TN type liquid crystal element 400 as it is, is reflected by the transmission/reflection type polarizer 300, goes back the way it came, and exits from the transmission/absorption type polarizer 500. An observer on the left side will observe a mirror image. Thus, the apparatus as a whole functions as a mirror.

There is also proposed a laminated assembly wherein a self light emitting device is laminated on a reflection type display device (for example, see JPA 2016-081052). It is used for example as display in a wrist watch etc. wherein the reflection type display device is used in bright circumstance and the self light emitting device is used in dark circumstance.

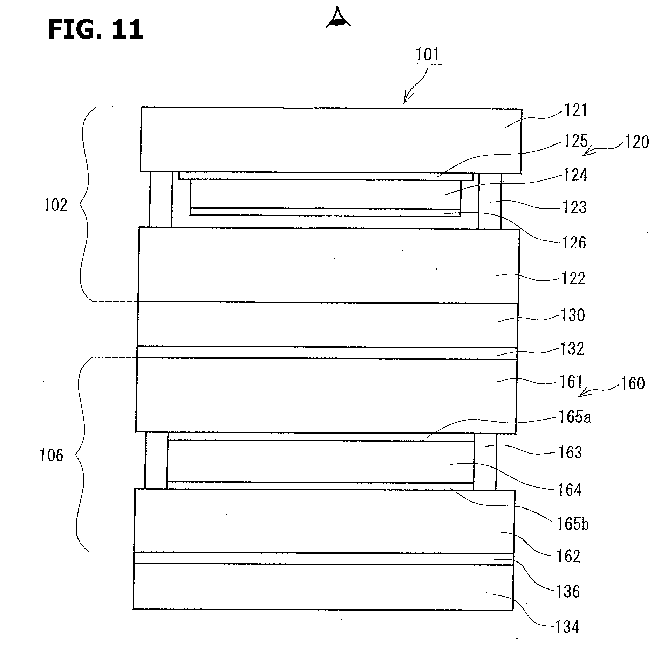

As illustrated in Fig. 11, a display assembly 101 includes a first display device 102 which is at least partially translucent or semi-transparent and self light emitting and is disposed to face an observer, and a second display device 106 which is disposed below the first display device, is partially translucent or semi-transparent. The first display device 102 can switch between at least partially translucent, passive state and an active state capable of emitting information displaying light. The reflective second display device 106 can switch between absorbing passive state and active state which can reflect ambient lights.

For example, the self light emitting first display device 102 is formed of a transparent organic light emitting diode display cell 120 (called TOLED display cell below), and the reflective second display device 106 is formed of a twisted nematic (TN) type reflective liquid crystal display cell 160.

In the TOLED display cell 120, a transparent substrate 121 and a capsulizing cover 122 made of glass or plastic material extend in parallel with a gap therebetween, are coupled by a sealing frame 123, and accommodate a stack 124 of electroluminescence layers. On both sides of the stack 124 of the electroluminescence layers, an upper side transparent electrode 125 formed of indium tin oxide (ITO) etc. and a lower side transparent electrode 126 formed of metallic material such as aluminum or gold, or such metal oxide as ITO or indium zinc oxide (IZO) are formed.

In the TN type reflective liquid crystal display cell 160, a front side substrate 161 and a back side substrate 162 extend in parallel with a gap therebetween, are coupled by a sealing frame 163, and define a hermetic space 164 for accomodating or containing liquid crystal. Orientation of the liquid crystal molecules accommodated in the hermetic space 164 can be controlled by applying an appropriate voltage between a transparent electrode 165a disposed on the lower surface of the front side substrate 161 and a counter transparent electrode 165b disposed on an upper surface of the rear side substrate 162. The electrodes 165a and 165b are formed of transparent conductive material such as IZO or ITO. As the liquid crystal, super-twisted nematic (STN) material and vertically aligned (VA) material can also be used in place of twisted nematic (TN) material.

On the upper surface of the front side substrate 161 of the reflective liquid crystal display cell 160, an absorptive polarizer 130 is bonded with an adhesive layer 132. The absorptive polarizer 130 is for example an iodine type or a dye type polarizer. An absorptive/reflective polarizer 134 is bonded to the lower surface of the rear side substrate 162 of the reflective liquid crystal display cell 160 with an adhesive layer 136.

The absorptive/reflective polarizer 134 reflects light components having polarization direction parallel to the reflection axis, and absorbs light components having polarization direction crossing the polarization direction of the reflected light components. It is stated that an absorptive polarizer disposed on a reflector, or a reflective transparent polarizer disposed on an absorptive layer can form an absorptive reflective polarizer 134.

When first and second mirror members are disposed to oppose each other, as mirrors set against each other, and light source(s) disposed between the two is (are) turned on, lights emitted from the light source may be multiply reflected between the first and second mirror members, being capable of performing display/illumination having depth in the field of view (for example, see JUMA 1981-139191).

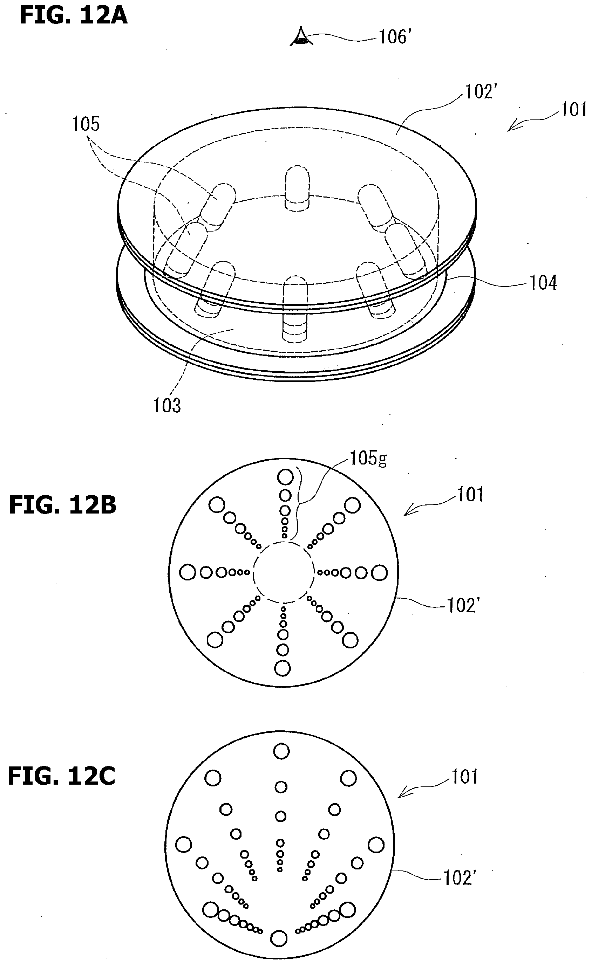

As illustrated in Fig. 12A, an optical system 101 is formed in which a first mirror member 102' which is a partly translucent mirror and a second mirror member 103 which is a totally reflective mirror are parallel supported through a cylindrical support 104 and a plurality of light sources 105 are disposed between them. Light beams emitted from the light sources 105 can be multiply reflected between the first and second mirror members. An observer 106' observes the optical system 101 from the side of the first mirror member 102' which is a partially translucent mirror, and observes multiply reflected light beams.

Fig. 12B is a plan view illustrating how the optical image will appear when an observer looks the optical system 101 from a central portion of the first mirror member 102' which is a partly translucent mirror. A plurality of optical images 105g are observed from the locations where the optical sources are really disposed toward the central portion. The outermost images correspond to the light beams which have not been reflected after the emission from the light sources and have transmitted through the first (partly translucent) mirror member 102', and are the images of the light sources themselves. Light beams emitted after multiple reflections by the first and second reflection members form virtual images of the light sources.

In correspondence with the number of multiple reflections, distances toward the virtual images of the light sources which are shifted toward the central portion increase, and the radii of the virtual images of the light sources become smaller. At a central portion, there exists dark portion where there is no optical image of the light sources.

Fig. 12C is a plan view of the optical system when the observer looks the first mirror member 102' of the optical system 101 from a position shifted from the central portion of the first mirror member. Positions of the virtual images of the optical sources and the dark portion change in accordance with the position of the observer.

As described above, when first and second mirror members, at least one of which is a semi-transparent or partly translucent mirror, are located to oppose each other and a light source is positioned between the two, and the optical system is observed from the side of the mirror member which is semi-transparent, a plurality of images of the optical source aligned in the depth direction of the field caused by multiple reflections can be observed. When the light source is a colored light source, the plurality of the images of the light source by the multiple reflections will also become colored images.

### SUMMARY OF THE INVENTION

When image formed by a display element is multiplexed along the depth direction in the field of view, impression given to an observer will be strengthened. When the depth itself in the field of view is varied, impression given to the observer will further become strong.

An optical apparatus according to an embodiment includes: first and second mirror devices disposed to oppose each other, each being capable of taking partially translucent state; and an image displaying device disposed between or on one outer side of said first and second mirror devices, and being capable of displaying an image.

Suppose an observer observes the image displaying device through the first and second mirror devices. When the first and second mirror devices are driven in transparent states, the image display device is observed as it is. When the first and second mirror devices are driven into partly translucent mirror states, multi-reflection occurs between the first and second mirror devices, and image formed by multiply reflected image of the image displaying device is observed. When the composite reflection ratio of the first and second mirror devices is changed, the order of multiple reflection can be changed and the depth of image can be changed.

### BRIEF DESCRIPTION OF THE DRAWINGS

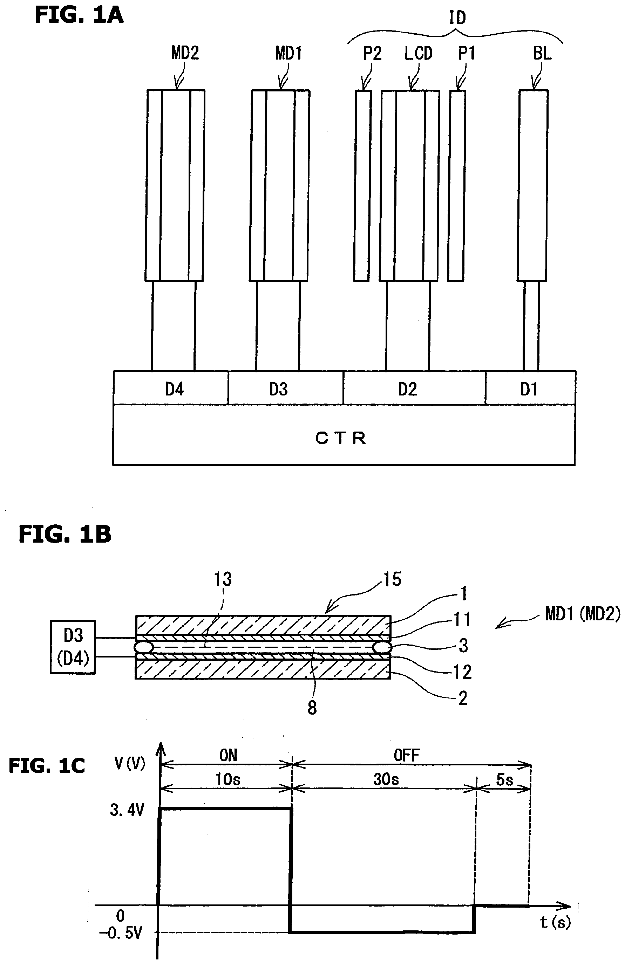

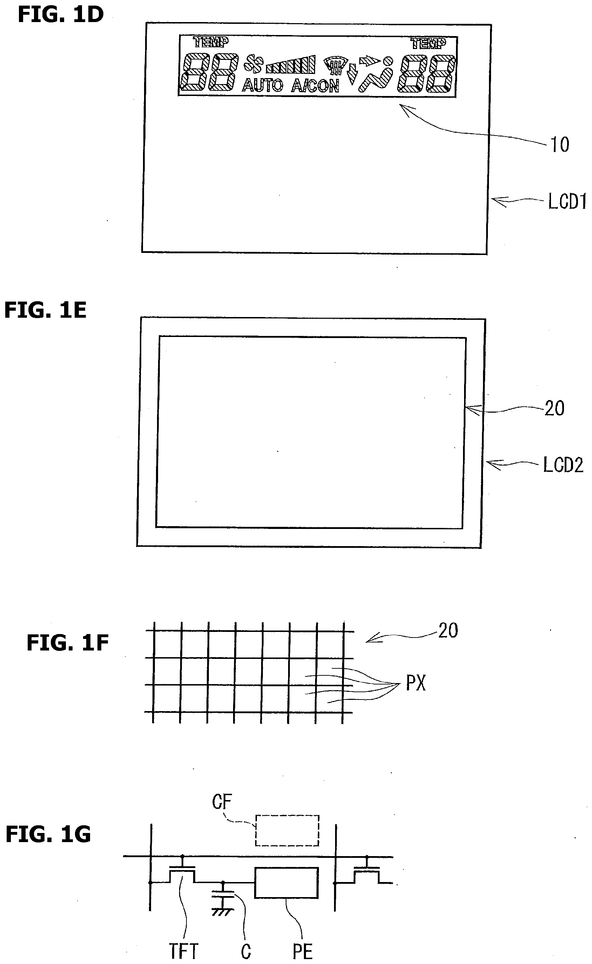

Fig. 1A is a cross-section of an optical apparatus according to a first embodiment in which first and second mirror devices which can become semi-transparent or partly translucent mirrors are disposed to oppose each other, and an image display unit containing a liquid crystal element is disposed outside one of the mirror devices, Fig. 1B is a cross-section illustrating structure of an electro-chemical element which can constitute the first and second mirror devices, Fig. 1C is a graph illustrating an example of driving voltage waveform for the electro-chemical element constituting the mirror device, Fig. 1D is a plan view illustrating an example of liquid crystal element having a segment display region, Fig. 1E is a plan view illustrating an example of liquid crystal element having a dot matrix display region, Fig. 1F is a plan view illustrating a structure of dot matrix display region, and Fig. 1G is a circuit diagram illustrating a structure of a single hue region.
Figs. 2A and 2B are plan views illustrating a real image and a multi-reflected image of the image display member observed through the second and the first mirror members in the first embodiment.
Figs. 3A, 3B, and 3C are schematic views illustrating the mechanism of forming virtual images, and Figs. 3D and 3E are graphs illustrating brightness of plurality of virtual images of the multiple reflection.
Fig. 4A is a cross-section illustrating a second embodiment in which an image display ID is formed of a self light emitting member, and Fig. 4B is a cross-section illustrating structure of a transparent organic light emitting diode (TOLED) or organic light emitting diode (OLED) which is an example of self light emitting member.
Fig. 5 is a cross-section schematically illustrating structure of an optical apparatus according to a third embodiment in which a self light emitting image display ID is disposed in an intermediate region between the first and second mirror devices.
Figs. 6A is a cross-section illustrating a mirror LCD used in place of an electro-chemical element which precipitates a mirror layer such as an Ag layer, and Fig. 6B is a graph illustrating example of characteristics.
Fig. 7 is a schematic cross-section illustrating an alternate example in which the first mirror device MD1 of the embodiment is exchanged with a mirror LCD.
Figs. 8A and 8B are schematic cross-sections illustrating functions of voltage absence state and voltage applied state of the alternate example illustrated in Fig. 7.
Fig. 9 is a schematic cross-section of alternate example in which the first and second mirror devices MD1 and MD2 of the first embodiment are replaced with mirror LCDs.
Figs. 10A and 10B are schematic cross-sections illustrating two states of an optical apparatus according to a first example of the related art.
Fig. 11 is a schematic cross-section illustrating a structure of an optical apparatus according to a second example of the related art.
Fig. 12A is a schematic perspective view illustrating a structure of a display in which a light source is disposed between opposed substrates and utilizes multiple reflection, according to a third example of the related art, and Figs. 12B and 12C illustrate examples of light source images displayed by the display.

### DESCRIPTION OF THE PREFERRED EMBODIMENTS

Fig. 1A is a cross-section schematically illustrating structure of an optical apparatus according to a first embodiment. A first mirror device MD1 and a second mirror device MD2 are located to face each other, and an image display ID is disposed right-hand outside of the first mirror device MD1.

The image display ID includes from the upstream side a back light BL, a first polarizer P1, a liquid crystal display LCD, and a second polarizer P2. A pair of polarizers P1 and P2 constitute cross polarizers or parallel polarizers, and form an image in combination with the liquid crystal display LCD. For example, when the liquid crystal display LCD is a vertically aligned liquid crystal display and the polarizers P1 and P2 are cross polarizers, lights from the back light BL are shaded in a cell with no voltage applied between the opposing electrodes to display black, and transmission lights appear in a cell with a voltage applied between the opposing electrodes to bring down or tilt the liquid crystal molecules to change display into white state.

In the case where the liquid crystal is twisted nematic (TN) liquid crystal and the polarizers P1 and P2 are parallel polarizers, black display can be done by a cell applied with no voltage, and white display can be done by a cell applied with a drive voltage. Example structures of image display ID having segment display provided with segment electrodes and dot matrix display provided with dot matrix electrodes will later be described.

The back light BL is connected with a driving power source D1, the liquid crystal display LCD is connected with a driving power source D2, the first mirror device MD1 is connected with a third driving power source D3, and the second mirror device MD2 is connected with a fourth driving power source D4. Controller unit CTR controls these power sources D1 to D4.

Fig. 1B is a cross-section illustrating example structure of the mirror device MD1 (MD2). Electrolytic solution 8 is injected into a cell 15 formed by coupling a glass plate having a transparent electrode 11 formed of ITO, IZO, etc. and another glass plate 2 having a similar transparent electrode 12 through a seal 3 to form an electro-chemical mirror device. The electrolytic solution 8 uses gamma-butyro-lactone (GBL) as solvent, AgBr as Ag salt, and LiBr as supporting salt. It also contains CuCl₂, GeCl₄, TaCl₅, or the like as mediator. When a dc voltage is applied from power source D3, an Ag film 13 is precipitated on a negatively biased electrode.

Solvent is not limited to GBL. It is only required that the solvent can stably maintain MD materials etc. For example, polar solvent such as water, non-polar organic solvent, ionic liquid, ion conducting polymer, polymer electrolyte, or the like can be used. Ag salt is not limited to AgBr. AgNO₃, AgClO₄, etc. can also be used as well as AgBr. Supporting salt is not limited to LiBr. Li salts such as LiCl, LiI, LiBF₄, LiClO₄, etc., K salts such as KCI, KBr, KI, etc., and Na salts such as NaCI, NaBr, NaI, etc. can also be used as well as LiBr.

Fig. 1C is a graph illustrating an example of driving voltage waveform for electro-chemical mirror element. Driving voltage for precipitating an Ag film in an electro-chemical mirror element to form a mirror surface is denoted as ON, and driving voltage for dissolving the Ag film by applying a reverses polarity voltage or applying no voltage is denoted as OFF.

The electro-chemical mirror element is driven at a constant frequency. There is provided ON period for depositing Ag film and OFF period for dissolving the Ag film, in one period. This is a driving voltage waveform for keeping the film thickness at a constant value and maintaining the optical reflectivity at a constant value. The thickness of the Ag film deposited in one period and the thickness of the Ag film decreased by dissolving are set equal to each other. It is also possible to change the optical reflectivity on the Ag deposition surface by increasing or decreasing the precipitation amount of Ag through adjusting the value of applied voltage. It is possible to realize transparent state, semi-transparent state, mirror state, etc. Construction examples of image display ID will further be described hereinafter.

Fig. 1D is a plan view illustrating a passive drive liquid crystal display element LCD1 having a segment display region 10. In a segment display region 10 within effective display region, segment electrodes of fixed shapes are disposed. The segment electrode has smoothly changing edge or edges. Counter electrode has an area containing or including the segment electrode. The segment electrode and the counter electrode jointly achieve display corresponding to the segment electrode shape. As examples, display of air-conditioner is illustrated, in which operating state of the air conditioner is illustrated at a central portion, and temperatures at the driver's seat and the assistant's seat are illustrated at the left and right portions.

Fig. 1E is a plan view illustrating an active drive liquid crystal display element LCD2 having a dot matrix display 20. In all the effective display area, dot matrix display 20 is formed.

Fig. 1F illustrates an example of a multiplicity of pixels PX regularly aligned in vertical and horizontal directions, in the dot matrix display 20. Pixels PX of rectangular shape are aligned along the vertical direction and the horizontal direction. Each pixel contains a plurality of single hue regions provided with corresponding color filters. In each pixel PX, single hue regions including red filter region, green filter region, and blue color region are arranged.

As illustrated in Fig. 1G, the single hue region electrode PE of the single hue region is provided with a storage capacitor C, and is connected with a thin film transistor TFT for switching image signal. A switching signal is supplied to a gate electrode of the thin film transistor TFT, image signal is stored in the storage capacitor C in ON period, and the stored image signal is maintained in OFF period. The single hue region electrode PE is covered with a color filter CF.

Returning to Fig. 1A, light image emitted from the image display ID is directed toward the mirror device pair MD1 and MD2. The image signal first transmits through the first mirror device which is partly translucent or semi-transparent, and then reaches the second mirror device D2. If the second mirror device D2 is partly translucent or semi-transparent, part of the lights is reflected to go back to the first mirror device MD1. If the first mirror device MD1 is partly translucent or semi-transparent, part of the lights is reflected to go back to the second mirror device MD2. In this way, multiple reflection occurs.

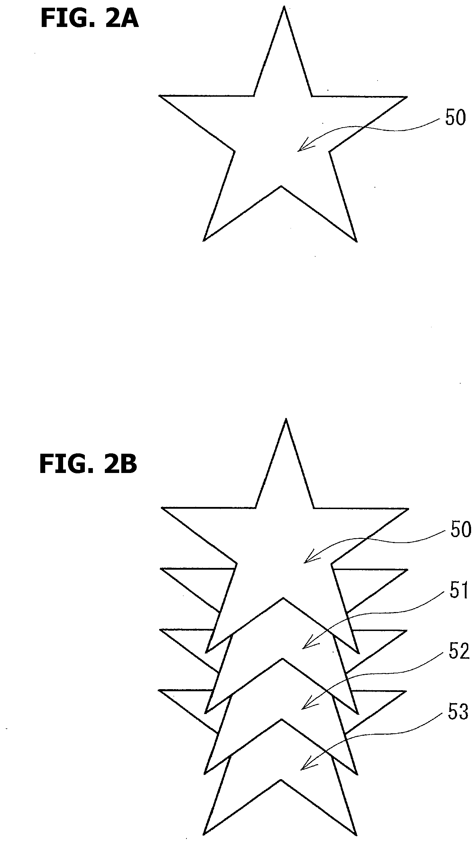

Figs. 2A and 2B illustrate example of images when the image display ID is observed through the second and first mirror devices MD2 and MD1 in the first embodiment. As illustrated in Fig. 2A, it is assumed that a star shaped light image is emitted from the image display ID. When the first and second mirror devices MD1 and MD2 are set as transparent and observation is made from the side of the second mirror device MD2, real image 50 of the image display is observed as it is.

As illustrated in Fig. 2B, when the second and first mirror devices MD2 and MD1 are set in semi-transparent mirror state, multiple reflection occurs between the second and first mirror devices MD2 and MD1, so that images 51, 52, 53, etc. which are made by multiple reflections of the image display ID are observed overlapping the real image 50. When the optical reflectivities of the first and second mirror devices are varied, the order of the multiple reflection can be varied, to change the depth of the images.

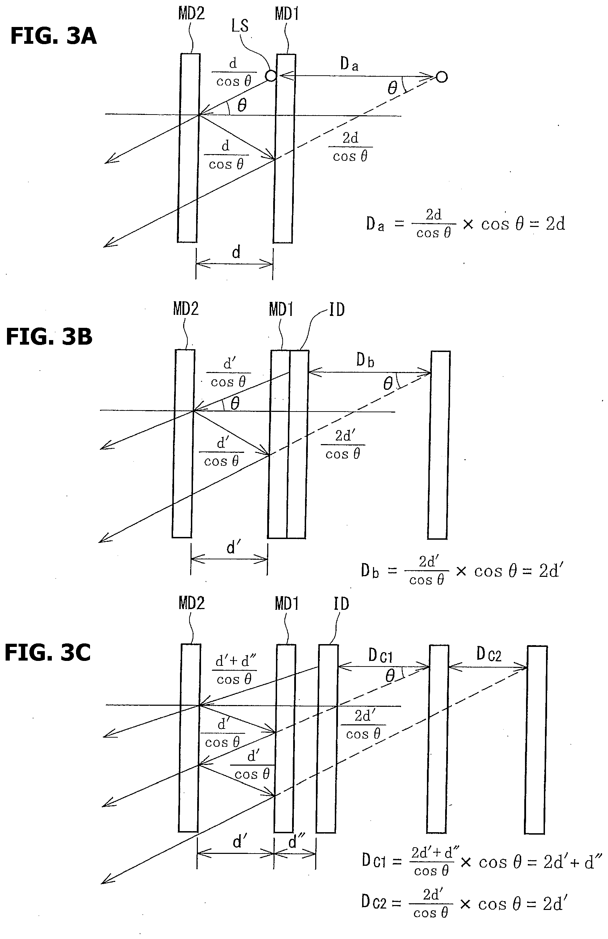

Figs. 3A, 3B, and 3C are schematic diagrams illustrating the mechanism of producing virtual images. First consideration will be made on a case where as illustrated in Fig. 3A first and second mirror devices MD1 and MD2 are located to face mutually, and a light source LS is disposed on the inner surface of the first mirror device MD1. Lights emitted from the light source LS are partly reflected by the second mirror device MD2. The reflected lights are then partly reflected by the first mirror device MD1. Further, reflections occur by the second and first mirror devices, generating multiple reflection.

The order of multiple reflection increase by one each time the light goes to and from between the opposing mirror devices. When the distance between the first mirror device and the second mirror device is denoted as d, the depth of the image space increases by 2d each time when the order of multiple reflection increases by one. When the first order multiple reflection is generated, the depth Da of the image space becomes 2d. When multiple reflection up to the n-th order is generated, the depth of the image space becomes 2nd, which is 2n times large as the real distance d of the opposing mirrors.

As illustrated in Fig. 3B, similar analysis can be made on a case where an image display ID is disposed outside the first mirror device MD1 or outside the second mirror device MD2. When the distance between the first mirror device and the second mirror device is denoted as d', the depth of the image space increases by 2d' each time when the order of multiple reflection increases by one. When the first order multiple reflection is generated, the depth Db of the image space becomes 2d'. When multiple reflection up to the n-th order is generated, the depth of the image space becomes 2nd', which is 2n times large as the real distance d' of the opposing mirrors. As illustrated in Fig. 3B, when an image display ID is disposed outside the facing mirror devices, more concretely when an image display ID is disposed on an outer surface of the first mirror device MD1, lights emitted from the image display ID transmit through the first mirror device MD1, are partly reflected by the second mirror device MD2, and the reflected lights are partly reflected by the first mirror device MD1, .... Reflection continues similar to the case of Fig. 3A, to constitute multiple reflection.

As illustrated in Fig. 3C, similar analysis can be made on a case where there exists some gap between the first mirror device MD1 and the image display ID. When the distance between the first mirror device and the second mirror device is denoted as d', and the distance between the first mirror device MD1 and the image display ID is denoted as d", the depth Dc1 of the image space increases by 2d' each time when the order of multiple reflection increases by one. When the first order multiple reflection is generated, the depth Dc1 of the image space becomes 2d' + d". When multiple reflection up to the n-th order is generated, the depth of the image space becomes 2nd' + d". The distance Dc2 between the adjacent two virtual images becomes 2d'.

When the image display ID is a tail lamp for vehicles, multiply reflected red alarm lamp will be extremely effective for attracting attention of the driver of a succeeding car. It will be appropriate to set the distance between the opposing mirror devices in a range from 1 cm to 50 cm. Considering other factors, it will be more appropriate to set the distance between the opposing mirror devices in a range from 2 cm to 30 cm. The first mirror device MD1 and the second mirror device MD2 are opposed (facing each other), and observation of the image display is assumed to be made from the side of the second mirror device MD2 through the mirror devices MD1 and MD2. When the composite optical reflectivity of the mirror devices is increased, the order of recognizable multiple reflection increases. When the composite optical reflectivity of the mirror devices is decreased, the order of recognizable multiple reflection decreases.

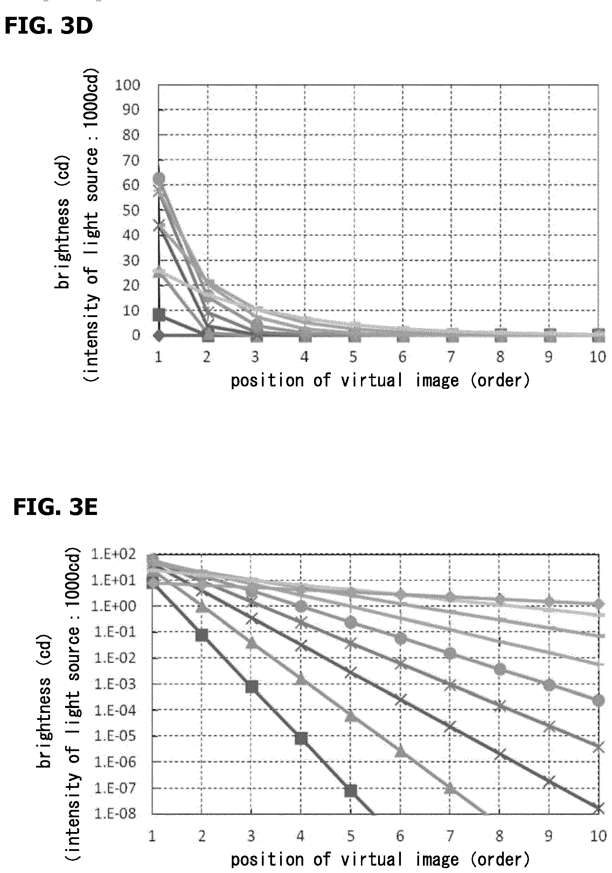

Fig. 3D is a graph of brightness of respective order lights in multiple reflection (ordinate) with respect to the position on the optic axis (abscissa). When the thickness of the Ag film(s) in the first and second mirror devices is increased in plural steps, the composite optical reflectivity increases in plural steps. As the position on the optic axis is deepened, brightness decreases.

Fig. 3E is a graph of the same contents with the ordinate in logarithmic scale. Change in the brightness of the respective order lights can be more clearly observed. For example when the axial position is shifted from position 5 to position 8, two higher order reflection lights become unobservable.

Consideration will be made on changing the optical reflectivity of a reflective film. When the optical reflectivity is increased, order of recognizable multiple reflection lights increases, and observation can be made up to deeper position. When the optical reflectivity is increased or decreased, the depth of observable image is increased or decreased. It becomes possible to provide novel images in which depth of image changes.

In the first embodiment, the first and second mirror devices MD1 and MD2 are disposed to oppose or face each other, and image display ID including a light source LS and a liquid crystal display LCD is disposed outside the mirror devices. The image display ID can take another construction.

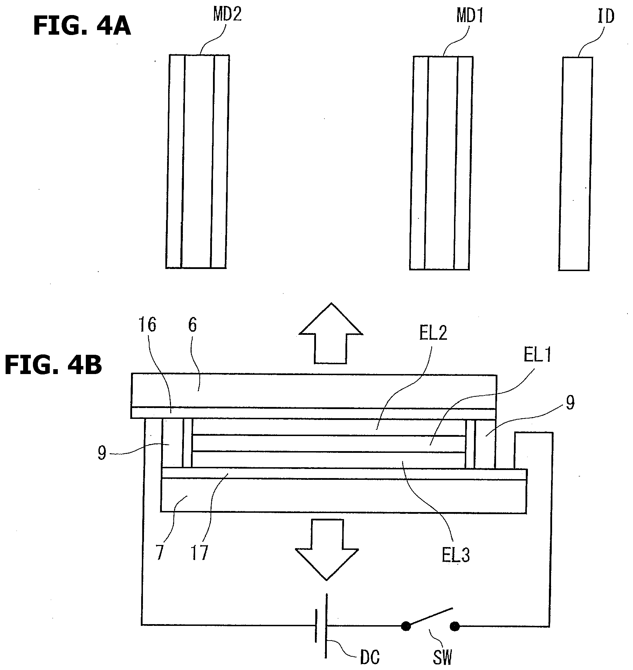

Fig. 4A illustrates a structure of a second embodiment in which self light emitting image display ID is used and a light source is dispensed with. As the self light emitting image display ID, it is possible to use organic light emitting diode (OLED) device or transparent organic light emitting diode (TOLED) device. The image display ID is formed only of transparent organic light emitting diodes, in place of the image display ID including a light source BL, pair of polarizers P1 and P2, and liquid crystal display LCD in the first embodiment.

Fig. 4B illustrates an example of a transparent organic light emitting diode (TOLED) display cell. A TOLED display cell mainly includes a pair of electrodes 16 and 17, and electroluminescence layers (electron transport layer EL2, light emitting active layer EL1, and positive hole transport layer EL3). Actually the electrodes 16 and 17 are constructed of light-transmissible conductive material such as indium tin oxide and are respectively provided on inside surfaces of transparent glass substrates 6 and 7. A seal member 9 surrounds the electroluminescence layers to shield them against the outside and to assist electrical insulation between the electrodes 6 and 7.

The active layer EL1 is sandwiched between the electron transport layer EL2 on one side and the positive hole transport layer EL3 on the other side to constitute lamination structure, which is disposed between the first transparent substrate 6 provided with the transparent electrode 16 and the second transparent substrate 7 provided with the transparent electrode 17. The two transparent electrodes 16 and 17 are connected with a dc power source DC through a switch SW. The seal 9 is disposed to enclose the lamination structure. Light emission occurs when power is supplied to the light emitting active layer EL1, and the output lights are emitted through the transparent electrodes 6 and 7 on both sides.

In the case of an OLED display cell, it is possible to form one electrode from light-transmissible conductive material such as indium tin oxide, and another electrode from metallic material. In the second embodiment illustrated in Fig. 4A in which image display ID is disposed outside the opposed mirror devices MD1 and MD2, a substrate not directed toward the mirror devices MD1 and MD2 may be formed of non- light-transmissible material such as silicon substrate, to form an organic light emitting diode (OLED). In this case, it is possible to incorporate a semiconductor integrated circuit.

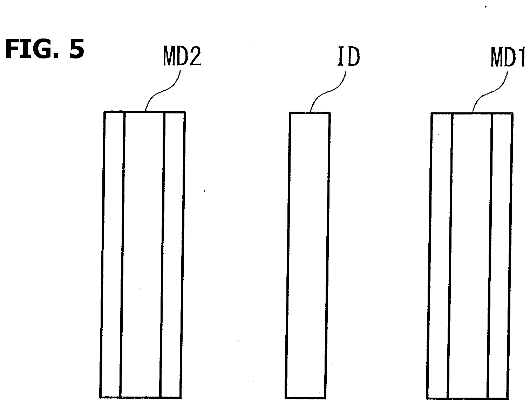

Fig. 5 illustrates a structure of a third embodiment in which an image display ID is disposed between the first and second mirror devices MD1 and MD2. When the image display ID is self light emitting and transparent or translucent, multiple reflection can occur even when the image display ID is disposed between the first and second mirror devices MD1 and MD2.

Above description is made on a case where electro-chemical mirror elements are used as mirror devices MD1 and MD2. Optical element which can control optical reflectivity is not limited to electro-chemical mirror element. It is only required that at least one of the opposing mirror devices is an optical element which can control optical reflectivity. For example, combination where a partly transparent mirror (half mirror) which reflects part of the incident lights and transmits part of the incident lights is used on one side and an electro-chemical mirror element is used on the other side.

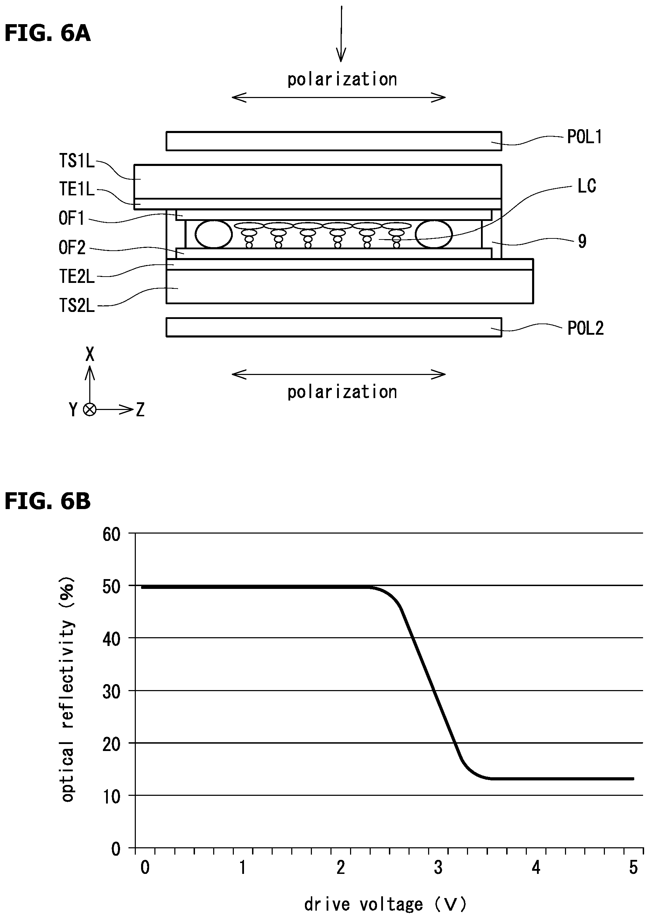

Fig. 6A is a cross-section of a structure of an example of mirror liquid crystal element 30 which uses liquid crystal and can control its optical reflectivity, which can be used as a replacement for the electro-chemical mirror element, and Fig. 6B is a graph illustrating an example of characteristics thereof. The mirror liquid crystal element 30 includes mainly a pair of electrodes TE1L and TE2L located to face each other, and a liquid crystal layer LC disposed between these electrodes TE1L and TE2L. The electrodes TE1L and TE2L are formed of translucent conducting material, for example indium tin oxide, etc. and are positioned on facing surfaces of transparent glass substrates TS1L and TS2I. Orientation films OF1 and OF2 may be formed to cover the electrodes TE1L and TE2L. Uniaxial orientation treatment such as rubbing is done on the orientation films OF1 and OF2.

The opposing electrodes TE1L and TE2L, and seal member 9 between the opposing substrates TS1L and TS2L define a predetermined space. For example, twisted nematic type liquid crystal material is injected in the space enclosed by the electrodes TE1L and TE2L and the seal 9, to constitute a liquid crystal layer LC. Pair of polarizers POL1 and POL2 are disposed outside the two transparent substrates TS1L and TS2L. The transmission axes of these polarizers are both directed along Z-axis, to constitute parallel Nicol.

Combination of parallel Nicol and TN liquid crystal layer can provide black display in the absence of applied voltage and white display in the presence of applied voltage. It is preferable that the absorption axis of the polarizer POL2 is along the same direction as the absorption axis of the polarizer P2 on the emission side of the image display ID. Also, it will be preferable to set the twist angle and the polarization axis in correspondence to the absorption axis of the polarizer POL2.

In stationary state (when no voltage is applied), liquid crystal molecules adjacent to the upper electrode TE1L are orientated for example along Z axis, and liquid crystal molecules adjacent to the lower electrode TE2L are orientated for example along Y axis. From the electrode TE1L to the electrode TE2L, the liquid crystal molecules are twistedly orientated to be twisted by 90 degrees. The liquid crystal layer LC in the stationary state (when no voltage is applied) changes the polarization axis of the incident linear polarization.

In the voltage applied state where a voltage is applied to the liquid crystal layer LC through the electrodes TE1L and TE2L, liquid crystal molecules which have been aligned almost in parallel to YZ plane are orientated to be along X axis (liquid crystal molecules stand to be orthogonal to the electrodes TE1L and TE2L). In this state, the liquid crystal layer LC does not change the polarization axis of the incident light, and transmits the incident light.

Fig. 6B is a graph illustrating characteristics of the mirror liquid crystal element 30. The abscissa represents drive voltage, and ordinate represents optical reflectivity. In Fig. 6A, incident lights come from the above side. Polarized lights parallel to Z axis transmit through the absorption type linear polarizer POL1 disposed above the liquid crystal layer LC, and are incident on the liquid crystal layer LC. In the state of no voltage application, the polarization axis of the incident lights are twisted by 90 degrees in the liquid crystal layer LC. The lower reflection type linear polarizer POL2 forms parallel Nicol with the upper absorption type linear polarizer POL1, and does not transmit the polarization which has been twisted by 90 degrees, and reflects the incident polarization. As illustrated in Fig. 6B, the optical reflectivity is high at low drive voltage region. When the drive voltage becomes somewhat high, the liquid crystal molecules stand up, and the incident lights become allowed to pass through the pair of polarizers in parallel Nicol. Along the increase in transmission ratio of incident lights, the optical reflectivity decreases. In Fig. 6B, the optical reflectivity has a constant low value in the region where the drive voltage is high, and represents a state of no reflected lights. In an intermediate region shifting from high reflectivity region to low reflectivity region, there exists a region where the optical reflectivity gradually decreases together with increase in the drive voltage.

It is made apparent that the mirror liquid crystal element 30 as illustrated in Fig. 6A can achieve similar functions as those of the electro-chemical mirror element as illustrated in Fig. 1B wherein an Ag film is precipitated. Although description has been made on a case where a liquid crystal layer and a pair of parallel Nicol polarizers are combined, it is also possible to combine a liquid crystal layer and a pair of cross Nicol polarizers. In this case, the system is light transmissible in no voltage application state, and becomes light reflective in voltage application state.

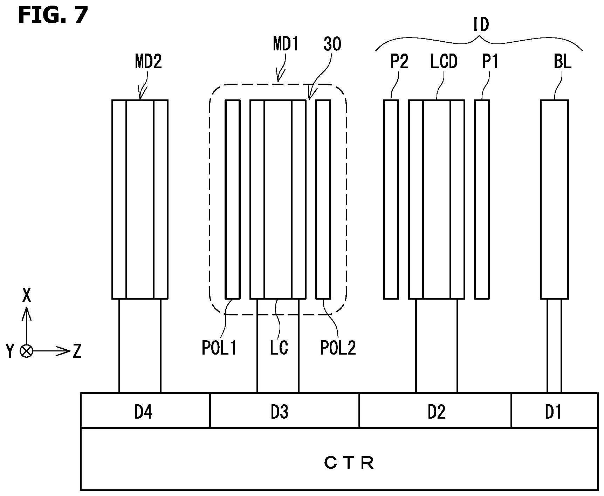

Fig. 7 illustrates alternative of the first embodiment where the first mirror device MD1 is formed of a mirror liquid crystal element as illustrated in Fig. 6A. The transmission axis of reflection type linear polarizer POL2 is aligned with the transmission axis of the polarizer P2 on the output side of the image display ID enabling take-in of the image lights.

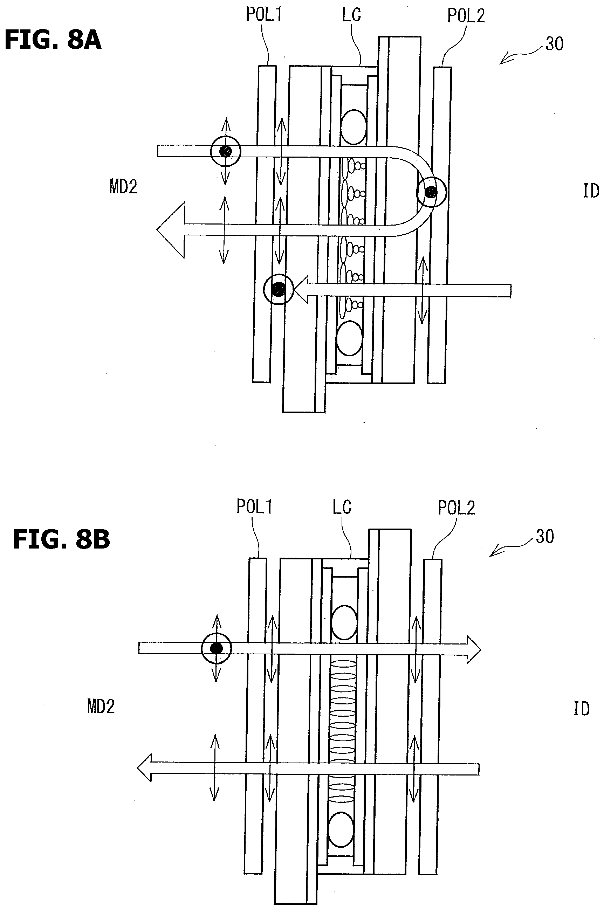

Figs. 8A and 8B are cross sections schematically illustrating the functions of the mirror liquid crystal element 30 in the no voltage application state and in the voltage application state. Fig. 8A illustrates no voltage application state. When no voltage is applied to the liquid crystal layer LC, vertically polarized lights coming from the left side polarizer POL1 and incident on the liquid crystal LC are twisted by 90 degrees to become orthogonal to the transmission axis of the reflection type parallel Nicol polarizer POL2 (parallel with the reflection axis), and are reflected at the reflection type polarizer POL2. With respect to lights coming from the left side, the optical reflectivity of the mirror liquid crystal element 30 is high. Lights coming from the right side image display ID transmits through the reflection type polarizer POL2 of the mirror liquid crystal element 30, are twisted their polarization axis by 90 degrees in the liquid crystal layer LC, and are blocked at the absorption type polarizer POL1.

Fig. 8B illustrates the voltage application state. When the voltage applied to the liquid crystal layer is made high, liquid crystal molecules stand vertical (orthogonal) to the substrate. The optical reflectivity of the mirror liquid crystal element 30 becomes low, suppressing the multiple reflection. In the voltage application state, liquid crystal molecules in the liquid crystal layer LC stand up, and the function of twisting the polarization axis of the incident lights decreases or is lost. Incident lights from the both sides transmitted through the pair of parallel Nicol polarizers POL1 and POL2 transmit through the liquid crystal layer LC.

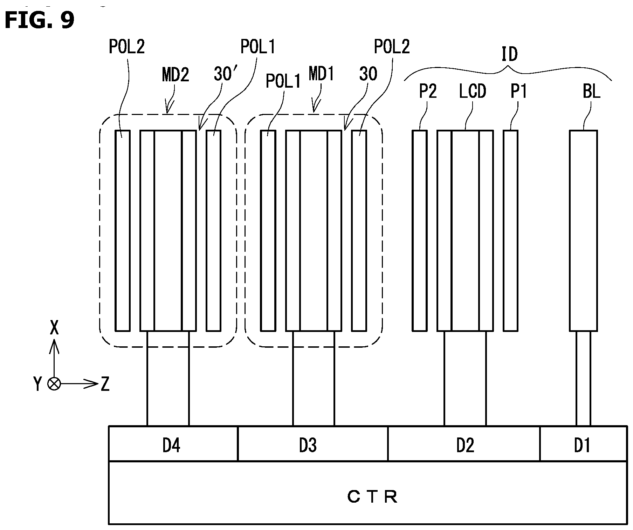

Fig. 9 illustrates alternative of the first embodiment where the first and second mirror devices MD1 and MD2 are both replaced with mirror liquid crystal elements. It is preferable the mirror liquid crystal element 30' of the second mirror device MD2 has a symmetrical structure to the mirror liquid crystal element 30 of the first mirror device MD1, where reflective polarizers POL2 are located on outer sides, and absorption type linear polarizers POL1 are located on the inner sides. Multiple reflection can occur between the pair of reflection type polarizers, to achieve similar functions. The change in the order of multiple reflection upon change in the composite reflectivity becomes large.

The mirror liquid crystal element 30' of the second mirror device MD2 may have a structure which has same directivity as the mirror liquid crystal element 30 of the first mirror device MD1. The reflection type polarizer POL2 of the mirror liquid crystal element 30 and the absorption type polarizer POL1 of the mirror liquid crystal element 30' may be disposed on the outer sides, and the absorption type polarizer POL1 of the mirror liquid crystal element 30 and the reflection type polarizer POL2 of the mirror liquid crystal element 30' may be disposed on the inner sides. It is also possible in this case to change the composite reflectivity to change the order of multiple reflection. Similar effects can be obtained even when the polarizers are disposed in the opposite directions.

Regarding the twisted nematic liquid crystal display, description has been made on the case of 90 degrees twist as an example. The twist angle is not limited to 90 degrees. The twist angle may be any angle between 60 degrees and 120 degrees.

When the twist angle of the liquid crystal element is changed from 90 degrees, it is preferable to set the angle between the polarization axes of the reflection type polarizer POL2 and the absorption type polarizer POL1 at an appropriate value. By setting such twist angle and the polarization axes, appropriate display characteristics can be provided over a wide viewing angle region.

The difference in the refractive index (birefringence) Δn of the liquid crystal layer LC formed of liquid crystal material is about 0.1. The thickness of a liquid crystal layer LC (cell thickness) d is of the order of 6.0 *µ*m. Thus, the retardation Δnd of the mirror liquid crystal element 30 is of the order of 0.6 *µ*m.

When such mirror liquid crystal element is replaced with electro-chemical mirror device, similar relation will be observed between the composite reflectivity and the order of multiple reflection.

Description has been made on preferred embodiments. These descriptions are not limitative unless otherwise described. For example, materials and numerical values described are only exemplary and can be varied in various ways. It will be apparent for those skilled in the art that various substitutions, alterations, combinations, etc. are possible.

## Claims

1. An optical apparatus comprising:
first and second mirror devices disposed to oppose each other, each being capable of taking partially reflective state; and
an image displaying device disposed between or on one outer side of said first and second mirror devices, and being capable of displaying an image.

2. The optical apparatus according to claim 1, wherein each of said first and second mirror devices is capable of changing optical reflectivity against incident light.

3. The optical apparatus according to claim 2, wherein said image displaying device includes a liquid crystal element and an illuminating back light.

4. The optical apparatus according to claim 2, wherein said image displaying device includes a light-transmissive light emitting diode disposed between said first and second mirror devices.

5. The optical apparatus according to claim 2, wherein at least one of said first and second mirror devices includes a cell capable of precipitating/dissolving an Ag film.

6. The optical apparatus according to claim 5, wherein optical reflectivity of said at least one of said first and second mirror devices is controllable by film thickness of said Ag film.

7. The optical apparatus according to claim 2, wherein at least one of said first and second mirror devices includes a first liquid crystal layer and a pair of polarizers sandwiching the first liquid crystal layer, at least one of which is a reflection type polarizer, constituting a mirror liquid crystal element.

8. The optical apparatus according to claim 7, wherein said mirror liquid crystal element includes a pair of electrodes sandwiching the first liquid crystal layer.

9. The optical apparatus according to claim 8, wherein said first liquid crystal layer presents twisted structure in absence of applied voltage.

10. A method of driving an optical apparatus comprising first and second mirror devices disposed to oppose each other, each being adjustable in optical reflectivity against incident light and being capable of taking partially reflective state, and an image displaying device disposed between or on one outer side of said first and second mirror devices, and being capable of displaying an image, the method comprising the steps of:
letting said first and second mirror devices in partially reflective state, enabling multiple reflection in space between said first and second mirror devices; and
enabling light injection from said image displaying device into the space between said first and second mirror devices, and light emission from the space between said first and second mirror devices toward external space.

11. The method of driving an optical apparatus according to claim 10, wherein at least one of said first and second mirror devices is constituted utilizing an electrochemical mirror element including a pair of opposing electrodes and electrolytic liquid disposed between said pair of opposing electrodes and containing Ag,
wherein said step of letting said first and second mirror devices in partially reflective state includes changing thickness of Ag film precipitated in said at least one mirror device, changing optical reflectivity.

12. The method of driving an optical apparatus according to claim 10, wherein at least one of said first and second mirror devices is constituted utilizing a mirror LCD including a first liquid crystal layer and a pair of polarizers sandwiching the first liquid crystal layer,
wherein said step of letting said first and second mirror devices in partially reflective state includes controlling orientation of liquid crystal molecules in the first liquid crystal layer, thereby changing polarization axis of polarized light transmitting through said first liquid crystal layer.

13. The method of driving an optical apparatus according to claim 10, further comprising the step of letting said first and second mirror devices in non-reflective state.
